# EUROPÄISCHE PATENTSCHRIFT

(11) **EP 3 229 269 B1**
(45) Veröffentlichungstag und Bekanntmachung des Hinweises auf die Patenterteilung: **21.07.2021**
(21) Anmeldenummer: 17164575.7
(22) Anmeldetag: 03.04.2017
(51) Int. Cl.: H01L 25/16

(54) **LED-MODUL IN CHIP-ON-BOARD-TECHNOLOGIE**
LED MODULE IN CHIP ON BOARD TECHNOLOGY
MODULE DEL SELON UNE TECHNOLOGIE CHIP ON BOARD

(30) Priorität: 06.04.2016 DE 102016205691
(43) Veröffentlichungstag der Anmeldung: 11.10.2017
(73) Patentinhaber: Tridonic GmbH & Co. KG, 6850 Dornbirn (AT)
(72) Erfinder: Bakk, Istvan, 2045 Törökbalint (HU)
(74) Vertreter: Rupp, Christian

(56) Entgegenhaltungen:
- DE-A1-102012 101 560
- DE-A1-102012 104 494
- DE-A1-102012 106 660
- DE-A1-102014 205 470

## Beschreibung

Die Erfindung betrifft ein LED-Modul in Chip-on-Board ("*COB*") Technologie. Die Erfindung betrifft darüber hinaus ein LED-Modul in COB-Technik kombiniert mit Surface-Mount-Technologie ("*SMT"*). Die Erfindung betrifft darüber hinaus ein Verfahren zur Herstellung eines LED-Moduls in COB-Technologie.

Die COB-Technologie (auch als *"Nacktchipmontage"* bekannt) ist ein Verfahren zur Direktmontage von ungehäusten Halbleiterchips auf Leiterplatten oder Trägersubstraten. Dabei wird ein gehäuseloser Halbleiterchip, englisch "*bare-chip*", direkt auf das Trägersubstrat platziert. Ein gehäuseloser Halbleiterchip wird auch als "*Nacktchip*" bezeichnet. Mit *"bare chip"* oder *"bare* die" werden integrierte elektronische Bauelemente bezeichnet, die nicht in einem Gehäuse verbaut sind, sondern ohne eigenes Gehäuse weiterverarbeitet werden. Sie werden direkt auf einer Leiterplatte oder einem keramischen Substrat aufgebracht und mittels Drahtbonden elektrisch mit umliegenden Bauelementen verbunden.

Leuchtmittel mittels LED zu betreiben ist seit längerem bekannt. Es ist erwünscht, den Aufbau und auch die Herstellung weiter zu vereinfachen.

Es ist daher bereits bekannt, LEDs als Leuchtmittel als LED-Chips direkt auf dem Trägersubstrat in COB-Technologie zu montieren.

Beispielsweise ist aus der EP 2 797 128 A1 bekannt, dass die zum Betreiben der LED benötigte elektrische Schaltung, insbesondere die Treiberschaltung mit der LED auf einem gemeinsamen Substrat platziert wird, um die Herstellungskosten für diese LED zu reduzieren.

Problematisch bei einer derartigen COB-Montage ist es, dass die zum Betreiben der LED benötigte elektronische Schaltung nicht vollständig als COB-Technologie bereitgestellt werden kann. Bislang ist nicht bekannt, ein LED-Modul vollständig in COB-Technologie herzustellen, welches mit Wechselspannung betrieben wird. So ist insbesondere beim direkten Betreiben von LED mittels Wechselspannung vorzusehen, dass die Wechselspannung gleichgerichtet und mit einer Überstrom- bzw. Überspannungsschutzeinrichtung, nachfolgend als Sicherung bezeichnet, ausgestattet ist. Weitere LED-Module sind beispielsweise aus DE102012101560 A1 und DE102014205470 A1 bekannt.

Bislang ist es nötig, zusätzliche Elemente, die nicht in COB-Technologie realisierbar sind, beispielsweise die Sicherung oder die Gleichrichterschaltung, als separate Module neben dem COB-Chip zu platzieren. Dieses Platzieren ist platzaufwendig und verteuert die Herstellung eines derartigen LED-Moduls.

Zudem ist sicherzustellen, dass die zum Absichern der Leuchtmittel benötigten Schutzabstände und Isolationen, insbesondere zum Verhindern eines Kriechstromabflusses und eines Spannungsübersprechens eingehalten werden.

Darüber hinaus können Spannungsfluktuationen dazu führen, dass das Leuchtmittel flackert oder im Extremfall zerstört wird. Es ist daher Aufgabe der hier vorliegenden Erfindung, ein LED-Modul bereitzustellen, welches mit Wechselspannung betreibbar ist und darüber hinaus kostengünstig hergestellt werden kann. Die gestellte Aufgabe wird mit den in den nebengeordneten Patentansprüchen beschriebenen Maßnahmen gelöst. Vorteilhafte Ausgestaltungen sind in den jeweils abhängigen Ansprüchen beschrieben.

Gemäß einem ersten Aspekt der Erfindung ist ein LED-Modul in COB-Technologie beschrieben. Das LED-Modul weist ein Basissubstrat auf, auf dem eine Isolationsschicht vollflächig ausgebildet ist. Auf der Isolationsschicht ist zumindest ein LED-Die direkt montiert. Das LED-Modul weist ferner auf:
- ein Aufbausubstrat, das auf der Isolationsschicht in räumlichem Abstand zu dem zumindest einen LED-Die ausgebildet ist; und
- zumindest einen weiteren Halbleiter-Die, der zumindest eine weitere elektronische Komponente aufweist, die dazu eingerichtet ist, den LED-Die zu beschalten.

Mit anderen Worten wird gemäß der Erfindung ein LED-Modul bereitgestellt, das zumindest einen LED-Die und zumindest einen weiteren Halbleiter-Die aufweisend zumindest eine weitere elektronische Komponente aufweist.

### Definition "Die":

Ein "*Die*" (Plural "*Dice*") ist in der Halbleitertechnik ein einzeln ungehäustes Stück eines Halbleiter-Wafers. Ein solches Die wird üblicherweise durch Sägen oder Brechen des fertig bearbeiteten Wafers in rechteckige Teile (dicing) gewonnen. In der Regel befindet sich auf einem Die ein Bauteil, beispielsweise ein Transistor, eine Leuchtdiode, oder eine komplexe Baugruppe, insbesondere ein integrierter Schaltkreis. Zum Beispiel wird ein Die, der eine Leuchtdiode (LED) aufweist, als LED-Die bezeichnet. Um möglichst lange an der Parallelfertigung auf dem Wafer zu profitieren, findet das Zerteilen im normalen Produktionsprozess zuletzt statt, direkt vor dem Einbau in ein Gehäuse bzw. dem Aufbringen auf einen Schaltungsträger. Die Begriffe "*Die*" und "*Chip*" werden im Folgenden synonym verwendet. Ungehäuste bzw. gehäuselose Chips werden im Englischen als *"bare chips"* bzw. im Deutschen als *"Nacktchips"* bezeichnet. Ein *"LED-Die"* bzw. *"LED-Chip"* entspricht einem ungehäusten Chip (*"bare chip"* oder *"Nacktchip"*).

Durch Ausgestalten des Basissubstrats mit einer Isolationsschicht wird sichergestellt, dass kein Kriechstrom oder eine Durchschlagspannung zum Zerstören oder Fehlbetreiben des LED-Moduls führen. Darüber hinaus ist die Isolationsschicht dazu vorgesehen, die LED-Dice zu kühlen.

Erfindungsgemäß ist der zumindest eine weitere Halbleiter-Die auf dem Aufbausubstrat in räumlichen Abstand zu dem zumindest einen LED-Die angeordnet; oder der zumindest eine weitere Halbleiter-Die ist, in nicht zur Erfindung gehörenden Ausführungsformen, direkt auf der Isolationsschicht in räumlichen Abstand zu dem zumindest einen LED-Die angeordnet.

Mit anderen Worten sind in dem LED-Modul vorzugsweise zwei Alternativen für die Anordnung des zumindest einen weiteren Halbleiter-Die mit der zumindest einen weiteren elektronischen Komponente vorgesehen.

Gemäß einer ersten erfindungsgemäßen Alternative (Alternative 1) ist der zumindest eine weitere Halbleiter-Die mit der zumindest einen weiteren elektronischen Komponente vorzugsweise auf dem Aufbausubstrat in räumlichem Abstand zu dem zumindest einen LED-Die angeordnet.

Gemäß einer zweiten nicht erfindungsgemäßen Alternative (Alternative 2) ist der zumindest eine weitere Halbleiter-Die mit der zumindest einen weiteren elektronischen Komponente direkt auf der Isolationsschicht in räumlichem Abstand zu dem zumindest einen LED-Die angeordnet.

Es können auch beide Alternativen zusammen in dem LED-Modul verwirklicht sein. D.h. das LED-Modul weist vorzugsweise auf:
- zumindest einen weiteren Halbleiter-Die mit zumindest einer weiteren elektronischen Komponente, der auf dem Aufbausubstrat in räumlichem Abstand zu dem zumindest einen LED-Die angeordnet ist (Alternative 1), und
- zumindest einen weiteren Halbleiter-Die mit zumindest einer weiteren elektronischen Komponente, der direkt auf der Isolationsschicht in räumlichem Abstand zu dem zumindest einen LED-Die angeordnet ist (Alternative 2).

Durch das räumliche Beabstanden des Aufbausubstrats von dem zumindest einen LED-Die (Alternative 1) sowie das räumliche Beabstanden des zumindest einen weiteren Halbleiter-Die mit der zumindest einen weiteren elektronischen Komponente von dem zumindest einen LED-Die (Alternative 1 und Alternative 2) ist sichergestellt, dass eine Wärmeentwicklung aufgrund des Betreibens des zumindest einen LED-Die nicht auf die zumindest eine weitere elektronische Komponente überstrahlt und eine Gewährleistung des Betreibens des LED-Moduls gegeben ist.

Vorzugsweise entspricht der räumliche Abstand zwischen dem zumindest einen weiteren Halbleiter-Die mit der zumindest einen weiteren elektronischen Komponente und dem zumindest einen LED-Die dem räumlichen Abstand zwischen der zumindest einen weiteren elektronischen Komponente und dem zumindest einen LED-Die .

Für den Fall, dass der zumindest eine weitere Halbleiter-Die und/oder die zumindest eine weitere elektronische Komponente durch eine Vergussmasse, beispielsweiße durch eine auf Silikon oder Epoxid basierte Vergussmasse, bedeckt ist bzw. vergossen ist, entspricht der räumliche Abstand von dem zumindest einem weiteren Halbleiter-Die mit der zumindest einen elektronischen Komponente zu dem zumindest einen LED-Die vorzugsweis zumindest 2,5 Millimeter (mm). Für den Fall, dass der zumindest eine weitere Halbleiter-Die und die zumindest eine weitere elektronische Komponente durch keine Vergussmasse bedeckt bzw. nicht vergossen ist, entspricht der räumliche Abstand von dem zumindest einem weiteren Halbleiter-Die mit der zumindest einen elektronischen Komponente zu dem zumindest einen LED-Die vorzugsweise zumindest 0,4 Millimeter (mm).

In einer bevorzugten Ausgestaltung weist das Aufbausubstrat eine erste Kavität auf, in der der zumindest eine LED-Die angeordnet ist. Der zumindest eine weitere Halbleiter-Die ist vorzugsweise in der Peripherie des Übergangs zwischen dem Aufbausubstrat und der ersten Kavität angeordnet.

Auf diese Weise kann der Herstellungsprozess vereinfacht werden, indem die LED-Dice in der ersten Kavität platziert werden.

Unter "der *Peripherie des Übergangs zwischen dem Aufbausubtrat und der ersten Kavität"* wird die Umgebung bzw. der Randbereich des Übergangs zwischen dem Aufbausubtrat und der ersten Kavität verstanden. Unter *"dem Übergang zwischen dem Aufbausubstrat und der ersten Kavität"* wird der Bereich bzw. die Stelle des Aufbausubstrats verstanden, bei der die erste Kavität in dem Ausbausubstrat beginnt bzw. endet.

Mit anderen Worten weist das Aufbausubstrat des oben beschriebenen LED-Moduls gemäß der ersten Alternative (Alternative 1) vorzugsweise eine erste Kavität auf, in der der zumindest eine LED-Die angeordnet ist, wobei der zumindest eine weitere Halbleiter-Die mit der zumindest einen weiteren elektronischen Komponente auf dem Aufbausubstrat in räumlichen Abstand von dem zumindest einen LED-Die angeordnet ist.

Das Aufbausubstrat des oben beschriebenen LED-Moduls gemäß der zweiten nicht erfindungsgemäßen Alternative (Alternative 2) weist vorzugsweise eine erste Kavität auf, in der der zumindest eine LED-Die angeordnet ist, wobei der zumindest eine weitere Halbleiter-Die mit der zumindest einen weiteren elektronischen Komponente direkt auf der Isolationsschicht in räumlichen Abstand von dem zumindest einen LED-Die angeordnet ist.

Somit bildet das Aufbausubstrat vorzugsweise einerseits einen Damm bzw. Dämme, um die erste Kavität der LED-Dice zu begrenzen. Dies stellt sicher, dass die Treiberschaltung von dem LED-Die räumlich beabstandet ist. Dies wird meist durch einen sogenannten Damm erreicht, der die Treiberschaltung von dem Leuchtmittel räumlich trennt. Der Damm wird dann beispielsweise dazu verwendet, um ein Ummanteln der LED-Dice zu ermöglichen.

Vorzugsweise ist an jedem Übergang bzw. Grenzbereich zwischen dem Aufbausubstrat und der ersten Kavität ein Damm ausgebildet bzw. angeordnet. Vorzugsweise ist an jedem Übergang bzw. Grenzbereich zwischen dem Aufbausubstrat und der ersten Kavität ein Damm auf der Isolationsschicht oder auf dem Aufbausubstrat angeordnet.

Vorzugsweise weist das auch eine elektrische Isolationsschicht bildende Aufbausubstrat eine Schichtdicke zwischen 0,8 und 3,2 Millimeter (mm), besonders vorzugsweise zwischen 1,4 und 1,8 Millimeter (mm) und ganz besonders vorzugsweise von 1,6 Millimeter (mm) auf.

Andererseits kann durch diese erste Kavität eine Umhüllung der LED-Dice, beispielsweise mit einem Konversionsmaterial, vereinfacht erfolgen.

Das Aufbausubstrat hat also vorzugsweise zwei Funktionen in dem erfindungsgemäßen LED-Modul. Zum einen dient das Aufbausubstrat vorzugsweise als Schicht, auf der der zumindest eine weitere Halbleiter-Die aufweisend die zumindest eine weitere elektronische Komponente angeordnet bzw. montiert werden kann (Alternative 1). Zum anderen dient das Aufbausubstrat vorzugsweise zum Ausbilden zumindest eines Damms an zumindest einem Randbereich der ersten Kavität des Aufbausubstrats, um z.B. ein Ummanteln von in der ersten Kavität angeordneten LED-Dice mit beispielsweise einem Konversionsmaterial zu ermöglichen.

Vorzugsweise ist der zumindest eine weitere Halbleiter-Die innerhalb oder außerhalb der ersten Kavität angeordnet.

In einer bevorzugten Ausgestaltung ist die Oberfläche des Basissubstrats optisch reflektierend und die Isolationsschicht ist optisch transparent oder reflektierend.

Auf diese Weise wird das Basissubstrat gleichzeitig als Reflektor verwendet. Dies ist insbesondere für die Einzel-LED-Module von Vorteil, da sich nun das Basissubstrat vereinfacht mit einem Reflektor ausstatten lässt. Die von dem LED-Die erzeugte Lichtstrahlung kann somit an dem Basissubstrat reflektiert werden, so dass der Absorptionskoeffizient verringert ist und das LED-Modul effizienter Licht abstrahlt.

Die Isolationsschicht ist vorzugsweise für die Wellenlänge des LED-Dice transparent.

In einer bevorzugten Ausgestaltung ist das Basissubstrat aus Aluminium, Silber oder Kupfer. Somit kann das Basissubstrat gleichzeitig als ein Kühlkörper verwendet werden, der die LED-Dice kühlt und eine zu starke lokale Wärmeentwicklung und daraus schlussfolgernde Zerstörung der LED-Dice verhindert.

In einer bevorzugten Ausgestaltung ist die Isolationsschicht aus einem anorganischen Material, insbesondere einem rotationsbeschichtetem Silizium oder einem SOL-Gel Siloxan. Durch diese Materialien wird die Durchschlagsspannung zwischen Basissubstrat und dem LED-Die vergrößert, da diese Materialien große Durchschlagsspannungs-Isolationswerte aufweisen, beispielsweise größer vier Kilovolt. Vorzugsweise wird die Isolationsschicht zusätzlich als Passivierungsschicht gegen Oxidierung angewendet. Mit anderen Worten stellt die Isolationsschicht vorzugsweise zusätzlich eine Passivierungsschicht gegen Oxidierung dar.

In einer bevorzugten Ausgestaltung ist die Isolationsschicht eine Keramik-Druckschicht. Mit einer derartigen Isolationsschicht sind Durchschlagsspannungs-Isolationswerte von 60 Volt gewährleistet.

In einer bevorzugten Ausgestaltung ist die Isolationsschicht eine Kunststoffschicht. Mit einer derartigen Isolationsschicht können die Isolierungsvorschriften für Direkt-AC sehr einfach eingehalten werden.

In einer bevorzugten Ausgestaltung ist der zumindest eine weitere Halbleiter-Die mit der zumindest einen weiteren elektronischen Komponente oder der zumindest eine LED-Die direkt auf dem Aufbausubstrat, auf der Isolationsschicht oder auf einem Submount als gehäuseloser Halbleiterchip montiert.

Vorzugsweise weist der Submount ein Keramikmaterial, wie z.B. Aluminiumoxid (Al₂O₃) oder Aluminiumnitrid (AlN) auf. Ferner weist der Submount vorzugsweise eine Dicke (Schichtdicke) zwischen 50 bis 200 Mikrometer (µm), besonders vorzugsweise zwischen 100 und 150 Mikrometer (µm) auf.

Vorzugsweise ist die zumindest eine weitere elektronische Komponente beispielsweise ein Feldeffekttransistor, eine Sicherung, ein Widerstand, eine Zenerdiode und/oder eine TVS-Diode, die vorzugsweise als gehäuseloser Halbleiterchip miniaturisiert ausgebildet ist.

Alternativ oder zusätzlich ist die weitere elektronische Komponente vorzugsweise ein Feldeffekttransistor, ein Mikrocontroller, eine Konstantstromquelle und/oder ein Gleichrichter.

Auf diese Weise ist die gesamte Versorgung der LED-Dice als COB-Technologie realisiert. Somit muss nun nur noch eine Wechselspannung an die weitere elektronische Komponente angelegt werden, um den LED-Die zu betreiben.

Alternativ oder zusätzlich können Teile der weiteren elektronischen Komponente nicht in COB-Technologie ausgeführt sein, insbesondere kann ein eingangsseitiger Brückengleichrichter des Direct-AC-LED-Moduls in einer anderen Technologie, beispielsweise in einer SMD-Bauweise ausgeführt sein.

In einer bevorzugten Ausgestaltung ist das Aufbausubstrat eine Leiterplatte bzw. Platine (englisch *"Printed-Circuit-Board-Material (PCB)"*)*,* vorzugsweise aus einem Verbundwerkstoff, besonders vorzugsweise aus FR-4 bzw. FR-4-Material.

In einer weiteren bevorzugten Ausgestaltung ist der Submount aus einem Keramikmaterial oder aus Silizium, vorzugsweise Aluminiumoxid (Al₂O₃) oder Aluminiumnitrid (AlN).

Mit anderen Worten ist das Aufbausubstrat und der Submount aus einem elektronisch isolierenden Material, das dazu geeignet ist, die weitere Komponente von dem Basissubstrat oder der Isolationsschicht elektrisch zu isolieren.

In einer bevorzugten Ausgestaltung weist das LED-Modul zumindest eine zweite Kavität auf; und der zumindest eine weitere Halbleiter-Die ist in der zumindest einen zweiten Kavität angeordnet.

Vorzugsweise ist die zumindest eine zweite Kavität eine Kavität des Aufbausubstrats. D.h. vorzugsweise weist das Aufbausubstrat die zumindest eine zweite Kavität auf.

Vorzugsweise ist die zumindest eine zweite Kavität innerhalb der ersten Kavität angeordnet.

In einer bevorzugten Ausgestaltung ist der zumindest eine weitere Halbleiter-Die mit einer reflektierenden oder transparenten Vergussmasse umhüllt und/oder abgedeckt.

Vorzugsweise entspricht die reflektierende oder transparente Vergussmasse zumindest einem reflektierenden oder transparenten Damm, der vorzugsweise zum Begrenzen der ersten Kavität im LED-Modul vorgesehen ist, wie vorstehend beschrieben. Alternativ entspricht die reflektierende oder transparente Vergussmasse vorzugsweise einer zusätzlichen reflektierenden oder transparenten Schicht.

In einer bevorzugten Ausgestaltung ist das Aufbausubstrat mit einer metallischen Oberfläche ausgestaltet bzw. das Aufbausubstrat weist eine metallisierte Oberfläche auf. Somit ist zwischen dem Aufbausubstrat und der weiteren elektronischen Komponente eine metallische Oberfläche ausgebildet, die zum elektrischen Verbinden der weiteren elektrischen Komponente und dem LED-Die verwendet werden kann. Diese metallische Oberfläche ist beispielsweise geätzt, so dass sich Leiterbahnen direkt auf dem FR-4-Material bzw. Keramikmaterial des Aufbausubstrats ausbilden können.

In einer bevorzugten Ausgestaltung ist der zumindest eine LED-Die mit einem Wellenlängenkonversionsmaterial umhüllt; oder der zumindest eine LED-Die und der zumindest eine weitere Halbleiter-Die ist mit einem Wellenlängenkonversionsmaterial umhüllt. Das Material ist beispielsweise Phosphor, um aus einer blau emittierenden LED Weißlicht zu machen. Jegliche Art von Mischlicht und Basiswellenlänge ist hierbei denkbar, um eine gezielte Wellenlänge zu erhalten.

In einer bevorzugten Ausgestaltung sind verschiedene LED-Dice mit unterschiedlichen Wellenlängenkonversions-materialien umhüllt. Auf diese Weise kann ein Mischlicht individuell eingestellt werden. Die gezielte Ansteuerung eines jeden LED-Die innerhalb des LED-Moduls kann somit die Farbtemperatur der ausgesendeten elektromagnetischen Strahlen variieren.

In einer bevorzugten Ausgestaltung weist das LED-Modul eine Sicherung als zumindest eine weitere elektronische Komponente auf, wobei die Sicherung als Bonddraht in einer Kavität des Aufbausubstrats ausgebildet ist. Kommt es nun zu einer Überspannung oder einem Überstrom, so schmilzt der Bonddraht aufgrund der gegebenen Durchmesser und schützt den zumindest einen LED-Die.

In einer alternativen Ausgestaltung ist die Sicherung als Drahtschleife ausgebildet. Dies ermöglicht es, dass auch nach Schmelzen des Drahts aufgrund eines Überstroms oder einer Überspannung keine elektrische Verbindung mehr zwischen dem LED-Die und der weiteren Komponente vorhanden ist.

In einer bevorzugten Ausgestaltung ist das LED-Modul mit einem transparenten oder transluzenten Material ummantelt. Auf diese Weise werden alle Komponenten des LED-Moduls geschützt und eine Abstrahlung des Lichts ist weiterhin gegeben.

In einer bevorzugten Ausgestaltung weist das Aufbausubstrat eine metallische Oberfläche auf, auf der die zumindest eine weitere elektronische Komponente angeordnet ist.

In einer bevorzugten Ausgestaltung der Erfindung sind zumindest Teile der zumindest einen weiteren elektronischen Komponenten in SMD-Technik ausgebildet.

Vorzugsweise sind alle elektronischen Komponenten, d.h. die zumindest eine weitere elektronische Komponente, des LED-Moduls als Halbleiter-Dice in dem LED-Modul bereitgestellt. Mit anderen Worten weist das LED-Modul zumindest einen weiteren Halbleiter-Die auf, der zumindest eine weitere elektronische Komponente aufweist. Ein weiterer Halbleiter-Die, der eine weitere elektronische Komponente aufweist, entspricht einer weiteren elektronischen Komponente die als Halbleiter-Die bereitgestellt wird. Vorzugsweise weist das LED-Modul derart eine beliebige Anzahl an weiteren Halbleiter-Dice auf, die jeweils eine beliebige Anzahl an elektronischen Komponenten aufweisen, dass jede elektronische Komponente des LED-Moduls Teil eines Halbleiter-Die ist, d.h. dass jede elektronische Komponente in dem LED-Modul als Halbleiter-Die bereitgestellt wird. Der zumindest eine LED-Die stellt auch einen Halbleiter-Die dar.

In einem weiteren Aspekt der Erfindung ist ein Verfahren zum Herstellen eines erfindungsgemäßen LED-Moduls in COB-Technologie (Chip-On-Board-Technologie) bereitgestellt. Dabei wird zunächst ein Basissubstrat bereitgestellt, auf dem eine Isolationsschicht vollflächig aufgetragen wird. In einem Folgeschritt wird zumindest ein LED-Die auf der Isolationsschicht montiert. Das Verfahren weist ferner die folgenden Verfahrensschritte auf:
- Ausbilden eines Aufbausubstrats auf der Isolationsschicht in räumlichem Abstand zu dem zumindest einem LED-Die; und/
- Montieren zumindest eines weiteren Halbleiter-Die in dem LED-Modul, wobei der zumindest eine weitere Halbleiter-Die zumindest eine weitere elektronische Komponente aufweist, die dazu eingerichtet ist, den LED-Die zu beschalten.

Mit anderen Worten stellt die Erfindung ein Verfahren zur Herstellung eines erfindungsgemäßen LED-Moduls gemäß den obigen Ausführungen bereit.

Erfindungsgemäß wird der zumindest eine weitere Halbleiter-Die auf dem Aufbausubstrat in räumlichen Abstand zu dem zumindest einen LED-Die montiert; oder der zumindest eine weitere Halbleiter-Die wird, in nicht zur Erfindung gehörenden Ausführungsformen, direkt auf der Isolationsschicht in räumlichen Abstand zu dem zumindest einen LED-Die montiert.

Mit anderen Worten stellt die Erfindung ein Verfahren zur Herstellung eines erfindungsgemäßen LED-Moduls bereit, bei dem der zumindest eine weitere Halbleiter-Die gemäß der Alternative 1 in dem LED-Modul angeordnet bzw. montiert wird.

Gemäß der ersten erfindungsgemäßen Alternative (Alternative 1) wird der zumindest eine weitere Halbleiter-Die aufweisend die zumindest eine weitere elektronische Komponente auf dem Aufbausubstrat in räumlichen Abstand zu dem zumindest einem LED-Die montiert bzw. angeordnet.

Gemäß der zweiten nicht erfindungsgemäßen Alternative (Alternative 2) wird der zumindest eine weitere Halbleiter-Die aufweisend die zumindest eine weitere elektronische Komponente direkt auf die Isolationsschicht in räumlichen Abstand zu dem zumindest einem LED-Die montiert bzw. angeordnet.

Es können auch beide Alternativen zusammen in dem LED-Modul verwirklicht sein. In diesem Fall wird zumindest ein weiterer Halbleiter-Die mit zumindest einer weiteren elektronischen Komponente auf dem Aufbausubstrat in räumlichem Abstand zu dem zumindest einen LED-Die angeordnet (Alternative 1), und zumindest ein weiterer Halbleiter-Die mit zumindest einer weiteren elektronischen Komponente wird direkt auf der Isolationsschicht in räumlichem Abstand zu dem zumindest einen LED-Die angeordnet (Alternative 2).

Vorzugsweise weist das Aufbausubstrat eine erste Kavität auf und der zumindest eine LED-Die wird vorzugsweise in der ersten Kavität auf der Isolationsschicht montiert. Hierbei wird vorzugsweise der zumindest eine weitere Halbleiter-Die in der Peripherie des Übergangs zwischen dem Aufbausubstrat und der ersten Kavität angeordnet.

Vorzugsweise wird der zumindest eine LED-Die in einer ersten Kavität des Aufbausubstrats auf der Isolationsschicht montiert, wobei der zumindest eine weitere Halbleiter-Die (aufweisend die zumindest eine weitere elektronische Komponente) vorzugsweise in der Peripherie des Übergangs zwischen dem Aufbausubstrat und der ersten Kavität
- auf dem Aufbausubstrat (Alternative 1) oder
- direkt auf der Isolationsschicht (Alternative 2) angeordnet bzw. montiert wird.

Vorzugsweise wird der zumindest eine weitere Halbleiter-Die innerhalb oder außerhalb der ersten Kavität angeordnet.

In einer bevorzugten Ausgestaltung weist das LED-Modul zumindest eine zweite Kavität auf und der zumindest eine weitere Halbleiter-Die wird in der zumindest einen zweiten Kavität angeordnet.

Vorzugsweise ist die zumindest eine zweite Kavität innerhalb der ersten Kavität angeordnet.

In einer bevorzugten Ausgestaltung weist das Verfahren ferner folgenden Verfahrensschritt auf:
- Umhüllen des zumindest einen LED-Die mit einem Wellenlängenkonversionsmaterial; oder
- Umhüllen des zumindest einen LED-Die und des zumindest einen weiteren Halbleiter-Die mit einem Wellenlängenkonversionsmaterial.

Optional wird der zumindest eine LED-Die mit einer transparenten oder transluzenten Umhüllung versehen, um den LED-Die zu schützen.

In einer bevorzugten Ausgestaltung wird der zumindest eine weitere Halbleiter-Die mit einer reflektierenden oder transparenten Vergussmasse umhüllt und/oder abgedeckt. Bevorzugt werden Teile der weiteren elektronischen Komponente nicht in COB-Technologie, sondern in einer SMD-Bauweise ausgeführt.

Nachfolgend wird anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein.

Es zeigen:
- Fig. 1: ein erstes bevorzugtes Ausführungsbeispiel eines erfindungsgemäßen LED-Moduls.
- Fig. 2: ein zweites bevorzugtes Ausführungsbeispiel eines erfindungsgemäßen LED-Moduls.
- Fig. 3: ein drittes bevorzugtes Ausführungsbeispiel eines erfindungsgemäßen LED-Moduls.
- Fig. 4: ein viertes bevorzugtes Ausführungsbeispiel eines erfindungsgemäßen LED-Moduls.
- Fig. 5a: ein fünftes bevorzugtes Ausführungsbeispiel eines nicht erfindungsgemäßen LED-Moduls.
- Fig. 5b: ein sechstes bevorzugtes Ausführungsbeispiel eines nicht erfindungsgemäßen LED-Moduls.
- Fig. 6: ein elektronisches Ersatzschaltbild eines bevorzugten Ausführungsbeispiels eines erfindungsgemäßen LED-Moduls.
- Fig. 7a-7d: ein siebtes bevorzugtes Ausführungsbeispiel eines erfindungsgemäßen LED-Moduls, teilweise in COB-Technologie und teilweise in SMT.
- Fig. 8: ein Verfahrensablaufdiagramm eines bevorzugten Ausführungsbeispiels eines erfindungsgemäßen Verfahrens.

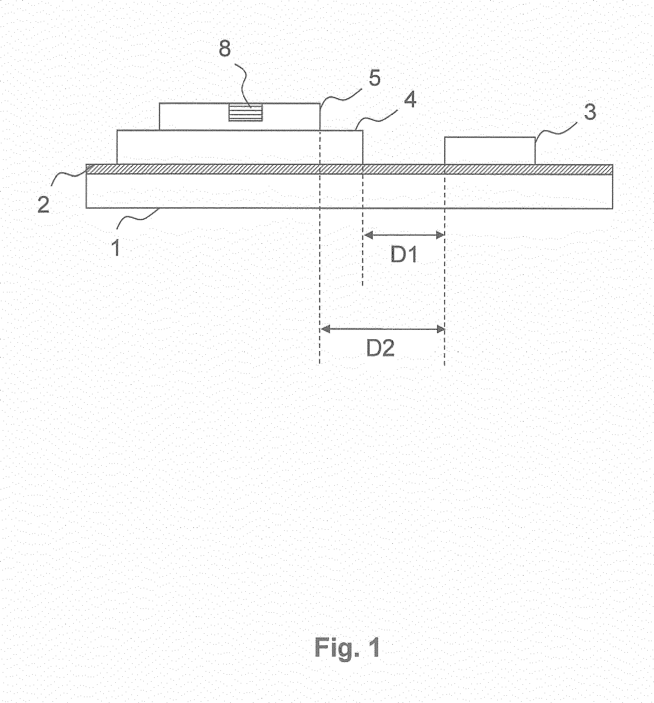

In Fig. 1 ist ein erstes bevorzugtes Ausführungsbeispiel eines erfindungsgemäßen LED-Moduls dargestellt. Das LED-Modul umfasst ein Basissubstrat 1, auf dem eine Isolationsschicht 2 vollflächig aufgetragen ist.

Auf der Isolationsschicht 2 ist ein als gehäuseloser Halbleiterchip ausgebildeter LED-Die 3 platziert. In einem räumlichen Abstand D1 zu dem LED-Die 3 ist ein Aufbausubstrat 4 ausgebildet. Auf dem Aufbausubstrat 4 ist in räumlichen Abstand D2 zu dem LED-Die 3 ein weiterer Halbleiter-Die 5 aufweisend eine weitere elektronische Komponente 8 montiert bzw. ausgebildet. Somit ist bezüglich der Anordnung des weiteren Halbleiter-Die 5 die oben beschriebene Alternative 1 in Fig. 1 gezeigt.

Alternativ zu dem in Fig. 1 gezeigten Ausführungsbeispiel kann der weitere Halbleiter-Die 5 mit der einen weiteren elektronischen Komponente 8 direkt auf der Isolationsschicht 2 in räumlichen Abstand D2 zu der LED-Die 3 montiert bzw. ausgebildet sein (Dies entspricht der oben beschriebenen nicht erfindungsgemäßen Alternative 2).

Obwohl in Fig. 1 nur ein LED-Die 3 und nur ein weiterer Halbleiter-Die 5 mit nur einer weiteren elektronischen Komponente 8 gezeigt ist, können gemäß der Erfindung auch mehr als ein LED-Die 3, mehr als ein weiterer Halbleiter-Die 5 sowie mehr als eine weitere elektronische Komponente 8 pro einen weiteren Halbleiter-Die 5 in dem LED-Modul vorhanden sein. Mit anderen Worten umfasst das erfindungsgemäße LED-Modul zumindest einen LED-Die 3 und zumindest einen weiteren Halbleiter-Die 5 aufweisend zumindest eine weitere elektronische Komponente 8, wobei der zumindest eine LED-Die 3 auf der Isolationsschicht 2 angeordnet ist und der zumindest eine weitere Halbleiter-Die 5 mit der zumindest einen weiteren elektronischen Komponente 8 in einem räumlichen Abstand D2 zu dem zumindest einen LED-Die 3 auf einem auf der Isolationsschicht 2 ausgebildeten Aufbausubstrat 4 (Alternative 1) oder direkt auf der Isolationsschicht 2 (Alternative 2) angeordnet ist.

Gemäß einer weiteren Alternative (Kombination aus der oben beschriebenen Alternative 1 und Alternative 2) zu dem in Fig. 1 gezeigten Ausführungsbeispiel ist zumindest ein weiterer Halbleiter-Die 5 mit zumindest einer weiteren elektronischen Komponente 8 auf einem auf der Isolationsschicht 2 ausgebildeten Aufbausubstrat 4 in räumlichen Abstand D2 zu der LED-Die 3 montiert bzw. ausgebildet und zumindest ein weiterer Halbleiter-Die 5 mit zumindest einer weiteren elektronischen Komponente 8 ist direkt auf der Isolationsschicht 2 in räumlichen Abstand D2 zu der LED-Die 3 montiert bzw. ausgebildet.

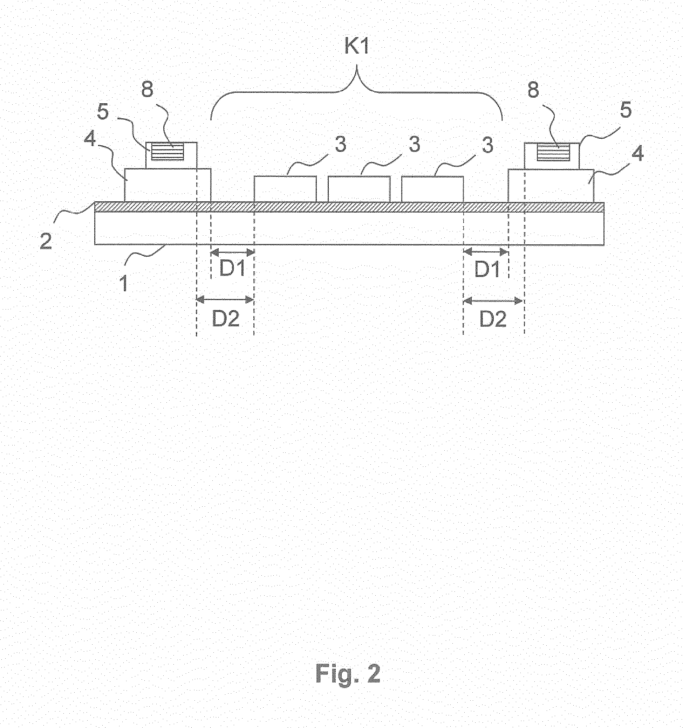

Der räumliche Abstand D1 entspricht dem Mindestabstand zwischen dem Aufbausubstrat 4 und dem zumindest einen LED-Die 3. Für den Fall, dass mehrere LED-Dice 3 auf der Isolationsschicht 2 angeordnet sind (siehe Fig. 2, 3, 4, 5a und 5b) entspricht der räumliche Abstand zwischen dem Aufbausubstrat 4 und jedem der LED-Dice 3 zumindest dem räumlichen Abstand D1. Mit anderen Worten kann der räumliche Abstand zwischen dem Aufbausubstrat 4 und einzelnen LED-Dice 3 auch größer als der Abstand D1 sein.

Der räumliche Abstand D2 entspricht dem Mindestabstand zwischen dem zumindest einen weiteren Halbleiter-Die 5 aufweisend die zumindest eine weitere elektronische Komponente 8 und dem zumindest einen LED-Die 3. Für den Fall, dass mehrere LED-Dice 3 auf der Isolationsschicht 2. angeordnet sind (siehe Fig. 2, 3, 4, 5a und 5b) entspricht der räumliche Abstand zwischen dem zumindest einen weiteren Halbleiter-Die 5 und jedem der LED-Dice 3 zumindest dem räumlichen Abstand D2. Mit anderen Worten kann der räumliche Abstand zwischen dem zumindest einen weiteren Halbleiter-Die 5 und einzelnen LED-Dice 3 auch größer als der Abstand D2 sein.

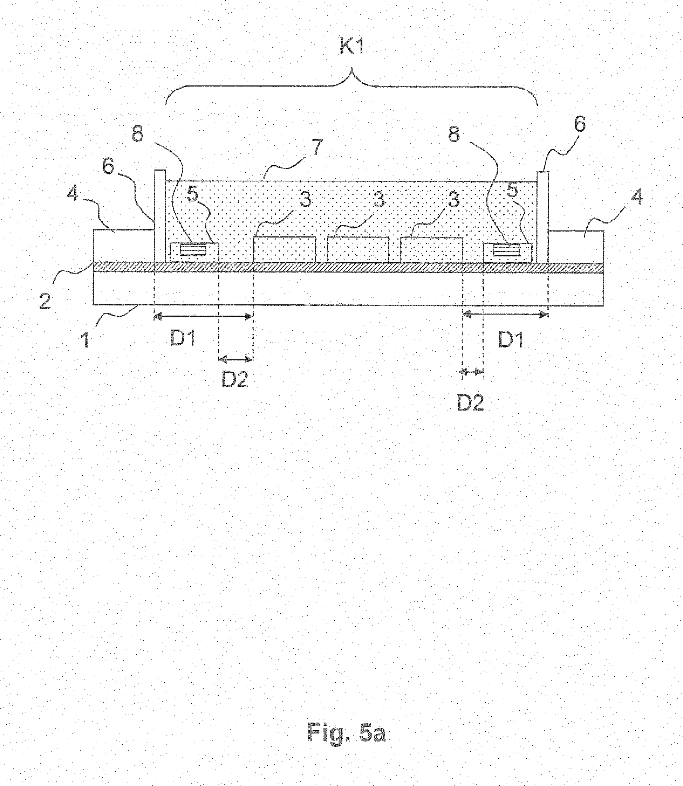

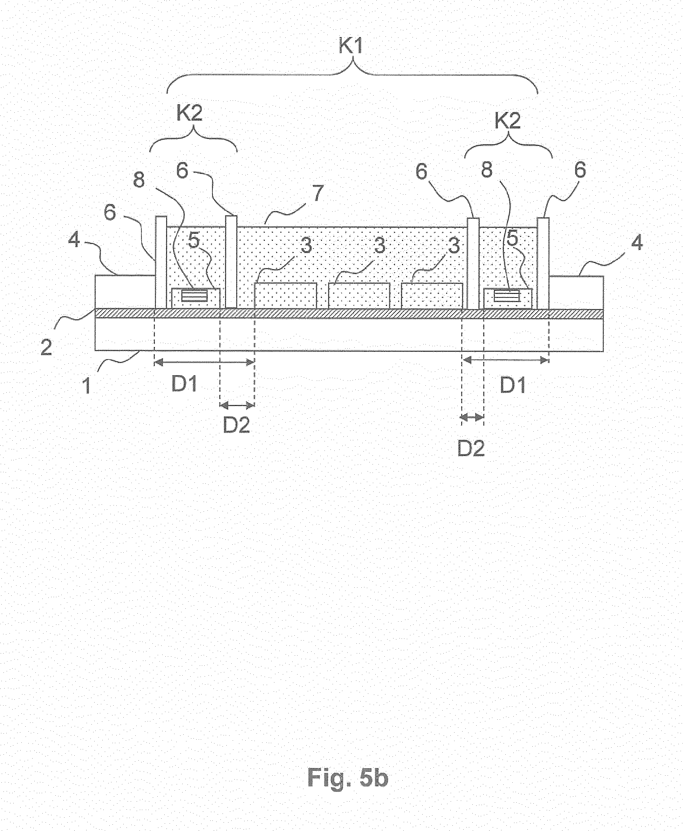

Gemäß Fig. 1 ist der Abstand D2 größer als der Abstand D1. Der Abstand D2 kann aber auch gleich groß wie der Abstand D1 sein. Ferner kann der Abstand D2 auch kleiner als der Abstand D1 sein (siehe Fig. 5a und 5b).

Für den Fall, dass der zumindest eine weitere Halbleiter-Die 5 und/oder die zumindest eine weitere elektronische Komponente 8 durch eine Vergussmasse, beispielsweiße durch eine auf Silikon oder Epoxid basierte Vergussmasse, bedeckt ist bzw. vergossen ist, entspricht der räumliche Abstand D2 von dem zumindest einem weiteren Halbleiter-Die 5 mit der zumindest einen weiteren elektronischen Komponente 8 zu dem zumindest einen LED-Die 3 vorzugsweis zumindest 2,5 Millimeter (mm). Für den Fall, dass der zumindest eine weitere Halbleiter-Die 5 und die zumindest eine weitere elektronische Komponente 8 durch keine Vergussmasse bedeckt bzw. nicht vergossen ist, entspricht der räumliche Abstand D2 von dem zumindest einem weiteren Halbleiter-Die 5 mit der zumindest einen weiteren elektronischen Komponente 8 zu dem zumindest einen LED-Die 3 vorzugsweise zumindest 0,4 Millimeter (mm).

Das Basissubstrat 1 ist vorzugsweise aus Metall, wie zum Beispiel Aluminium, Silber oder Kupfer. Da Aluminium, Silber oder Kupfer nicht direkt als Basismaterial verwendet werden kann, um eine ausreichende Isolation zum LED-Die 3 zu bewerkstelligen, ist eine Isolationsschicht 2 vorzusehen. Die Isolationsschicht 2 ist beispielsweise als transparente Isolationsschicht 2 auf dem Aluminiumsubstrat 1 aufgetragen. Diese Isolationsschicht 2 kann aus organischem oder anorganischem Material ausgebildet sein. Beispielsweise kann eine Siliziumschicht oder ein SOL-Gel-Siloxan verwendet werden, um die Isolationsschicht 2 bereitzustellen. Durch die Isolationsschicht 2 wird gewährleistet, dass eine sehr hohe Durchschlagsspannung, beispielsweise größer 4 Kilovolt benötigt wird, um den LED-Die 3 zu zerstören.

Das Aufbausubstrat 4 entspricht vorzugsweise einer Platine bzw. Leiterplatte ("*Printed-Circuit-Board*/*PCB"*) und ist folglich vorzugsweise aus einem Material (PCB-Material), das für Leiterplatten verwendet wird. Daher ist das Aufbausubstrat 4 vorzugsweise aus einem Verbundwerkstoff, wie beispielsweise aus FR-4 bzw. FR-4-Material, hergestellt. FR-4-Material wird beispielsweise für die klassische Leiterplattenmontage verwendet.

Vorzugsweise ist ein LED-Die 3 oder ein weiterer Halbleiter-Die 5 auf einem Submount angeordnet (in Fig. 1 nicht gezeigt), wobei der Submount vorzugsweise aus einem Keramikmaterial, wie beispielsweise aus Aluminiumoxid (Al₂O₃) oder aus Aluminiumnitrid (AlN), hergestellt ist. Der LED-Die 3 oder der weitere Halbleiter-Die 5 kann durch den Submount auf dem Aufbausubstrat 4 angeordnet sein (in Fig. 1 nicht gezeigt).

Ein Submount weist vorzugsweise eine Dicke (Schichtdicke) zwischen 50 bis 200 Mikrometer (µm), besonders vorzugsweise zwischen 100 und 150 Mikrometer (µm) auf.

Auf dem Aufbausubstrat 4 ist vorzugsweise ein als gehäuseloser Halbleiterchip ausgebildeter Feldeffekttransistor oder eine Mikrocontrollerschaltung oder eine Konstantstromquelle oder ein Gleichrichter als weitere elektronische Komponente 8 ausgebildet. Diese als gehäuseloser Halbleiterchip ausgebildete weitere elektronische Komponente 8 wird in einem weiteren Halbleiter-Die 5 platziert und ermöglicht es, dass das gesamte LED-Modul als COB-Technologie hergestellt werden kann. Somit kann einerseits der Kriechstrom und die Durchschlagsspannung eingehalten werden und darüber hinaus das LED-Modul miniaturisiert hergestellt werden.

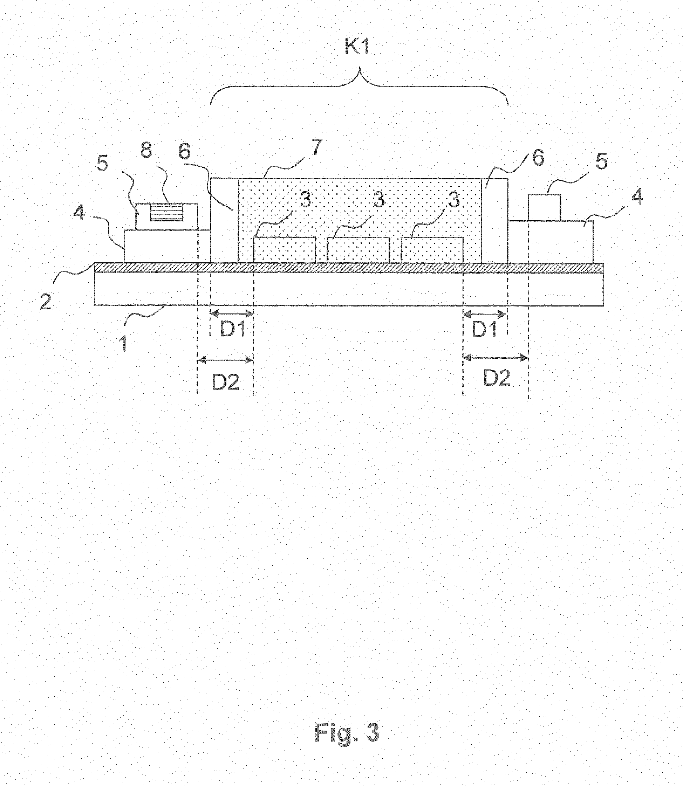

Bevorzugt ist eine Vielzahl von LED-Dice 3 ausgebildet. Jedes einzelne der LED-Dice 3 ist mit einer Phosphorummantelung umhüllt, wohingegen die weiteren elektronischen Komponenten 8 im Halbleiter-Die 5 in einer Peripherie außerhalb der ersten Kavität K1 eines Aufbausubstrats 4 ausgebildet sind (siehe z.B. Fig. 3).

Dabei ist vorzugsweise vorgesehen, dass eine metallische Oberseite des Aufbausubstrats 4 verwendet wird, um die weiteren elektronischen Komponenten 8 elektrisch leitend zu verbinden und eine Wärmeleitfähigkeit bereitzustellen.

Alternativ wird als Isolationsmaterial eine Keramik-Tinte verwendet. Diese ermöglicht eine Durchschlagsspannungssicherheit von bis zu 60 Volt.

In Fig. 2 ist ein zweites bevorzugtes Ausführungsbeispiel eines LED-Moduls gemäß der Erfindung dargestellt. Die vorstehenden Ausführungen bezüglich der bevorzugten Ausführungsform eines erfindungsgemäßen LED-Moduls gemäß der Fig. 1 sind im Wesentlichen für das in Fig. 2 gezeigte bevorzugte Ausführungsbeispiel eines erfindungsgemäßen LED-Moduls zutreffend. Gemäß Fig. 2 sind eine Vielzahl von LED-Dice 3 auf einer Isolationsschicht 2 eines Basissubstrats 1 montiert. Die LED-Dice 3 sind in einer ersten Kavität K1 eines Aufbausubstrats 4 angeordnet. Die LED-Dice 3 sind in einem ausreichenden räumlichen Abstand D1 zum Aufbausubstrat 4 und in einem ausreichend räumlichen Abstand D2 zu den weiteren elektronischen Komponenten 8 in den weiteren Halbleiter-Dice 5 angeordnet.

Vorzugsweise ist der räumliche Abstand D1 und der räumliche Abstand D2 von dem Durchmesser der ersten Kavität K1 und des vorzugsweise ein Spot Light Engine Modul darstellenden LED-Moduls abhängig. Der Durchmesser der ersten Kavität K1 bzw. des Damms 6 (siehe z.B. Fig. 3) ist vorzugsweise zwischen 5,8 und 22,8 Millimeter (mm), besonders vorzugsweise 16,8; 18,8 oder 22,8 Millimeter (mm).

In Fig. 3 ist ein drittes bevorzugtes Ausführungsbeispiel eines erfindungsgemäßen LED-Moduls dargestellt. Die vorstehenden Ausführungen bezüglich der bevorzugten Ausführungsform eines erfindungsgemäßen LED-Moduls gemäß den Fig. 1 und 2 sind im Wesentlichen für das in Fig. 3 gezeigte bevorzugte Ausführungsbeispiel eines erfindungsgemäßen LED-Moduls zutreffend. Im Unterschied zu Fig. 2 sind zusätzliche Dämme 6 dargestellt, um das Aufbausubstrat 4 von den in der ersten Kavität K1 angeordneten LED-Dice 3 zu trennen.

Mit anderen Worten sind die Dämme 6 jeweils an einem Übergang bzw. in einem Grenzbereich zwischen dem Aufbausubstrat 4 und der ersten Kavität K1 angeordnet, wobei die Dämme 6 vorzugsweise aus dem Aufbausubstrat gebildet werden. Das heißt jeder Damm 6 entspricht vorzugsweise einem Aufbausubstrat, dessen Schichtdicke bzw. Höhe größer als die Schichtdicke bzw. Höhe des restlichen Aufbausubstrats 4 in dem LED-Modul ist.

Vorzugsweise weist das Aufbausubstrat 4 eine Schichtdicke zwischen 0,8 und 3,2 Millimeter (mm), vorzugsweise zwischen 1,4 und 1,8 Millimeter (mm) und ganz vorzugsweise von 1,6 Millimeter (mm) auf.

Diese Dämme 6 sind gemäß Fig. 3 dazu vorgesehen, um eine Umhüllung der in der ersten Kavität K1 angeordneten LED-Dice 3 mit einem Wellenlängenkonversionsmaterial 7 zu ermöglichen. Die Dämme 6 stellen dabei eine Begrenzung der LED-Dice-Umhüllung 7 dar. Dieses Konversionsmaterial 7 ist beispielsweise Phosphor, um aus einer Primärwellenlänge der LED-Die 3 eine Sekundärwellenlänge zu bilden, so dass ein Mischlicht entsteht, welches von dem LED-Modul beispielsweise als Weißlicht abgestrahlt wird.

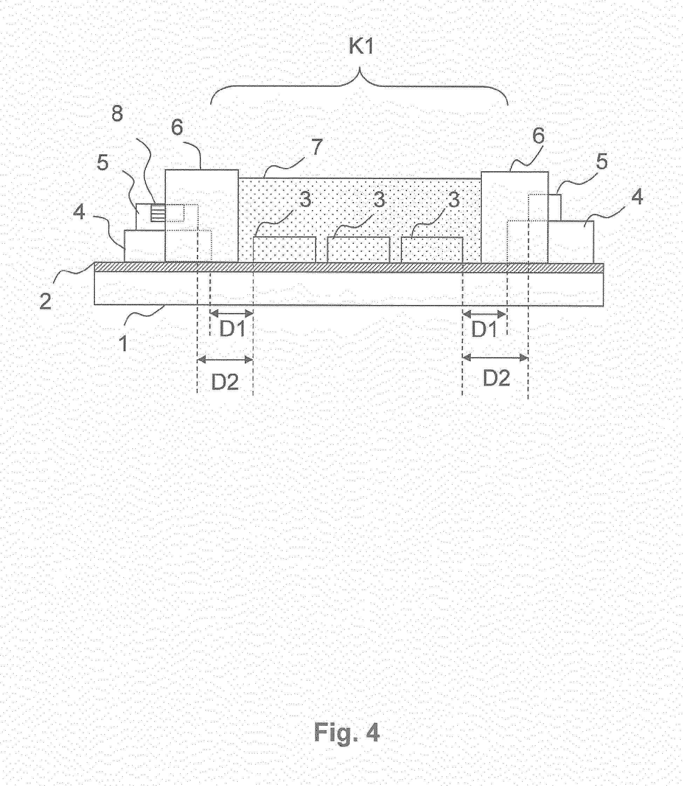

In Fig. 4 ist ein viertes bevorzugtes Ausführungsbeispiel eines erfindungsgemäßen LED-Moduls dargestellt. Die vorstehenden Ausführungen bezüglich der bevorzugten Ausführungsform eines erfindungsgemäßen LED-Moduls gemäß den Fig. 1, 2 und 3 sind im Wesentlichen für das in Fig. 4 gezeigte bevorzugte Ausführungsbeispiel eines erfindungsgemäßen LED-Moduls zutreffend.

Vorzugsweise ist der zumindest eine weitere Halbleiter-Die 5 und/oder die zumindest eine weitere elektronische Komponente 8 des zumindest einen weiteren Halbleiter-Die 5 zumindest teilweise durch eine reflektierende Vergussmasse, welche vorzugsweise einem reflektierenden Damm 6 entspricht, ummantelt und/oder abgedeckt. Hierbei stellt die reflektierende Vergussmasse vorzugsweise eine reflektierende Polymer-Matrix dar, welche vorzugsweise aus Silikon oder Epoxidharz (Epoxid) mit reflektierenden Partikel besteht. Die reflektierenden Partikel entsprechen zum Beispiel Titandioxid (TiO₂), Aluminiumoxid (Al₂O₃), und/oder Bariumtitanat (BaTiO₃).

Gemäß Fig. 4 ist an beiden Übergängen zwischen dem Aufbausubstrat 4 und der ersten Kavität K1 ein Damm 6 angeordnet, wobei die Schichtdicke bzw. Höhe der beiden Dämme 6 größer als die Schichtdicke bzw. Höhe des Aufbausubstrats 4 ist. Die Länge der zwei Dämme 6 der Fig. 4 ist größer als die Länge der zwei Dämme 6 der Fig. 3.

Wie in dem Ausführungsbeispiel der Figur 3, sind die zwei Dämme 6 an den beiden Übergängen zwischen der Kavität K1 und dem Aufbausubstrat 4 gemäß Fig. 4 dazu vorgesehen, um eine Umhüllung der in der ersten Kavität K1 angeordneten LED-Dice 3 mit einem Wellenlängenkonversionsmaterial 7 zu ermöglichen. Die Dämme 6 stellen dabei eine Begrenzung der LED-Dice-Umhüllung 7 dar. Dieses Konversionsmaterial 7 ist beispielsweise Phosphor, um aus einer Primärwellenlänge der LED-Dice 3 eine Sekundärwellenlänge zu bilden, so dass ein Mischlicht entsteht, welches von dem LED-Modul beispielsweise als Weißlicht abgestrahlt wird.

Gemäß Fig. 4 sind die Dämme 6 ferner dazu vorgesehen, um die weiteren Halbleiter-Dice 5, welche in einem Abstand D2 von den LED-Dice 3 in der Peripherie bzw. Umgebung des Übergangs zwischen der Kavität K1 und dem Aufbausubstrat 4 auf dem Aufbausubstrat 4 angeordnet sind, und die zumindest eine weitere elektronische Komponente 8 zumindest teilweise zu ummanteln und/oder abzudecken. Vorzugsweise sind die Dämme 6 gemäß der Fig. 4 reflektierende Dämme, welche vorzugsweise eine reflektierende Polymer-Matrix darstellen und vorzugsweise aus Silikon oder Epoxidharz (Epoxid) mit reflektierenden Partikel bestehen. Gemäß den obigen Ausführungen entsprechen die reflektierenden Partikel zum Beispiel Titandioxid (TiO₂), Aluminiumoxid (Al₂O₃), und/oder Bariumtitanat (BaTiO₃).

Fig. 5a zeigt ein fünftes bevorzugtes Ausführungsbeispiel eines nicht erfindungsgemäßen LED-Moduls. Die vorstehenden Ausführungen bezüglich der bevorzugten Ausführungsform eines erfindungsgemäßen LED-Moduls gemäß den Fig. 1, 2, 3 und 4 sind im Wesentlichen für das in Fig. 5a gezeigte bevorzugte Ausführungsbeispiel eines erfindungsgemäßen LED-Moduls zutreffend.

Vorzugsweise ist der zumindest eine weitere Halbleiter-Die 5 aufweisend die zumindest eine weitere elektronische Komponente 8 in einem räumlichen Abstand D2 direkt auf der Isolationsschicht 2 montiert. Ferner ist der zumindest eine weitere Halbleiter-Die 5 mit der zumindest einen weiteren elektronischen Komponente 8 vorzugsweise in der Peripherie bzw. Umgebung des Übergangs zwischen dem Aufbausubstrat 4 und der ersten Kavität K1 angeordnet, wobei der zumindest eine weitere Halbleiter-Die 5 vorzugsweise innerhalb oder außerhalb der ersten Kavität K1 angeordnet ist. Vorzugsweise können sowohl innerhalb wie auch außerhalb der Kavität K1 weitere Halbleiter-Dice 5 in dem LED-Modul angeordnet sein.

Gemäß Fig. 5a sind zwei weitere Halbleiter-Dice 5 mit jeweils einer weiteren elektronischen Komponente 8 in einem räumlichen Abstand D2 von den LED-Dice 3 in der Kavität K1 direkt auf der Isolationsschicht 2 angeordnet bzw. montiert. Fig. 5a zeigt also den Fall, in dem die weiteren Halbleiter-Dice 5 innerhalb der Kavität K1 in der Peripherie bzw. Umgebung des Übergangs zwischen dem Aufbausubstrat 4 und der ersten Kavität K1 angeordnet bzw. montiert sind.

Wie in dem Ausführungsbeispiel der Figuren 3 und 4, sind zwei Dämme 6 an den beiden Übergängen zwischen der Kavität K1 und dem Aufbausubstrat 4 gemäß Fig. 5a dazu vorgesehen, um eine Umhüllung der in der ersten Kavität K1 angeordneten LED-Dice 3 mit einem Wellenlängenkonversionsmaterial 7 zu ermöglichen. Die Dämme 6 stellen dabei eine Begrenzung der LED-Dice-Umhüllung 7 dar. Dieses Konversionsmaterial 7 ist beispielsweise Phosphor, um aus einer Primärwellenlänge der LED-Die 3 eine Sekundärwellenlänge zu bilden, so dass ein Mischlicht entsteht, welches von dem LED-Modul beispielsweise als Weißlicht abgestrahlt wird. Die Länge der Dämme 6 gemäß der Fig. 5a sind kürzer als die Länge der Dämme 6 der Fig. 3 und 4.

Gemäß Fig. 5a werden auch die zwei in der Kavität K1 angeordneten weiteren Halbleiter-Dice 5 aufweisend jeweils eine weitere elektronische Komponente 8 durch das Wellenlängenkonversionsmaterial 7 umhüllt. Folglich werden also vorzugsweise der zumindest eine LED-Die 3 und der zumindest eine weitere Halbleiter-Die 5 aufweisend die zumindest eine weitere elektronische Komponente 8 mit einem Wellenlängenkonversionsmaterial 7 umhüllt.

Gemäß Fig. 5a ist der räumliche Abstand D2 zwischen den weiteren Halbleiter-Dice 5 und den LED-Dice 3 kleiner als der räumliche Abstand D1 zwischen dem Aufbausubstrat 4 und den LED-Dice 3. Vorzugsweise kann der Abstand D2 aber auch größer als (siehe Fig. 1, 2, 3 und 4) oder gleich groß wie der Abstand D1 sein.

Fig. 5b zeigt ein sechstes bevorzugtes Ausführungsbeispiel eines nicht erfindungsgemäßen LED-Moduls. Die vorstehenden Ausführungen bezüglich der bevorzugten Ausführungsform eines erfindungsgemäßen LED-Moduls gemäß den Fig. 1, 2, 3, 4 und 5a sind im Wesentlichen für das in Fig. 5b gezeigte bevorzugte Ausführungsbeispiel eines erfindungsgemäßen LED-Moduls zutreffend.

Das LED-Modul gemäß der Fig. 5b entspricht im Wesentlichen dem LED-Modul gemäß der Fig. 5a, wobei in der Kavität K1 des LED-Moduls der Fig. 5b zwischen jedem weiteren Halbleiter-Die 5 und den LED-Dice 3 jeweils ein Damm 6 angeordnet bzw. ausgebildet ist, der den jeweiligen weiteren Halbleiter-Die 5 von den LED-Dice 3 trennt. Gemäß Fig. 5b entsteht durch das Ausbilden zweier zusätzlicher Dämme 6 in der ersten Kavität K1 zwei weitere Kavitäten K2, in denen jeweils ein weiterer Halbleiter-Die 5 aufweisend zumindest eine weitere elektronische Komponente 8 angeordnet ist. Folglich weist das LED-Modul vorzugsweise zumindest eine zweite Kavität K2 auf, in der vorzugsweise der zumindest eine weitere Halbleiter-Die 5 aufweisend die zumindest eine weitere elektronische Komponente 8 angeordnet ist. Hierbei ist die zumindest eine zweite Kavität K2 vorzugsweise innerhalb der ersten Kavität K1 angeordnet. Vorzugsweise weist das Aufbausubstrat 4 (neben der ersten Kavität K1) zumindest eine zweite Kavität K2 auf.

Optional ist der in der zumindest einen zweiten Kavität K2 angeordnete zumindest eine weitere Halbleiter-Die 5 und/oder die zumindest eine weitere elektronischen Komponenten 8 des zumindest einen weiteren Halbleiter-Die 5 durch eine reflektierende Vergussmasse, vorzugsweise durch einen reflektierenden Damm 6, zumindest teilweise ummantelt und/oder abgedeckt (nicht in Fig. 5b gezeigt). Diese reflektierende Vergussmasse bzw. dieser reflektierende Damm 6 stellt vorzugsweise eine Polymer-Matrix dar, welche vorzugsweise aus Silikon oder Epoxidharz (Epoxid) mit reflektierenden Partikel besteht. Die reflektierenden Partikel sind zum Beispiel Titandioxid (TiO₂), Aluminiumoxid (Al₂O₃), und/oder Bariumtitanat (BaTiO₃).

Folglich können die zwei weiteren Halbleiter-Dice 5 in den zwei zweiten Kavitäten K2 gemäß der Fig. 5b und/oder die jeweilige zumindest eine weitere elektronische Komponente 8 durch die jeweiligen Dämme 6 zumindest teilweise ummantelt und/oder abgedeckt sein, wobei die Dämme 6 dann vorzugsweise reflektierende Dämme sind.

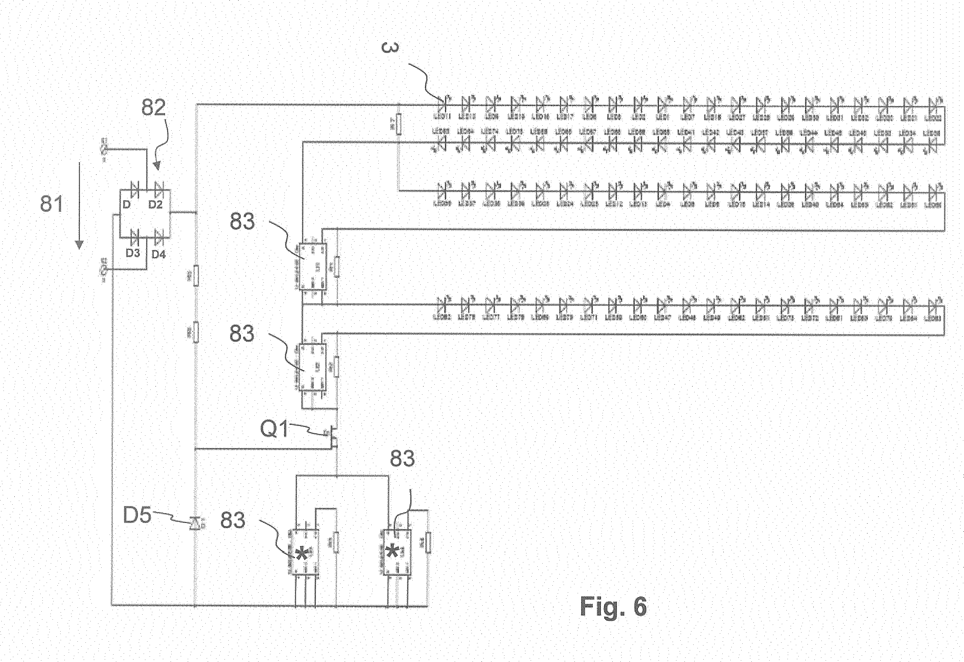

In Fig. 6 ist ein beispielhaftes Ersatzschaltbild eines bevorzugten Ausführungsbeispiels eines erfindungsgemäßen LED-Moduls dargestellt. Dabei wird eine Wechselspannung an die Netz-Wechselspannungsanschlüsse 81 angeschlossen. Die Wechselspannung weist beispielsweise eine Höhe von 230V auf. Diese Wechselspannung wird mittels eines Gleichrichters 82 gleichgerichtet und vier Mikrocontrollern 83 bereitgestellt an welchen eine LED-Strecke aus 84 LEDs 3 angeschlossen ist. Diese LED-Strecke wird entsprechend der Höhe der gleichgerichteten Wechselspannung beschaltet, wobei die Mikrocontroller 83 Teile der LED-Strecke überbrücken können. Eines oder beide der in Fig. 6 mit einem Sternchen ("*") markierten Komponenten 83 entsprechen vorzugsweise einer Konstantstromquelle. Somit umfasst das LED-Modul gemäß der Fig. 6 eine weitere elektronische Komponente 8, die einem Gleichrichter 82 entspricht, und vier weitere elektronische Komponenten 8, die Mikrokontrollern 83 bzw. Konstantstromquellen 83 entsprechen.

Um nun alle elektronischen Komponenten 8 auf dem LED-Modul in COB-Technologie bereitstellen zu können, wird jedes der Komponenten 82 und 83 gemäß Fig. 6 als weitere elektronische Komponente 8 in einem Halbleiter-Die 5 auf einem Aufbausubstrat 4 (Alternative 1) oder direkt auf der Isolationsschicht 2 (Alternative 2) im Abstand D2 zum LED-Die 3 angeordnet. Auf diese Weise ist eine vollständige Integration aller Schaltungskomponenten zum Betreiben eines LED-Moduls mit Wechselspannung erhalten.

Somit kann ein Spot Light Modul für Spot Light Engine (SLE) oder Spot Light Luminaire Anwendungen bereitgestellt werden. Dabei wird der Kriechstrom eine Sicherheitsbeabstandung, eine Wärmeleitfähigkeit und auch ein Gleichrichten der Wechselspannung mittels eines einzigen COB-Moduls erhalten.

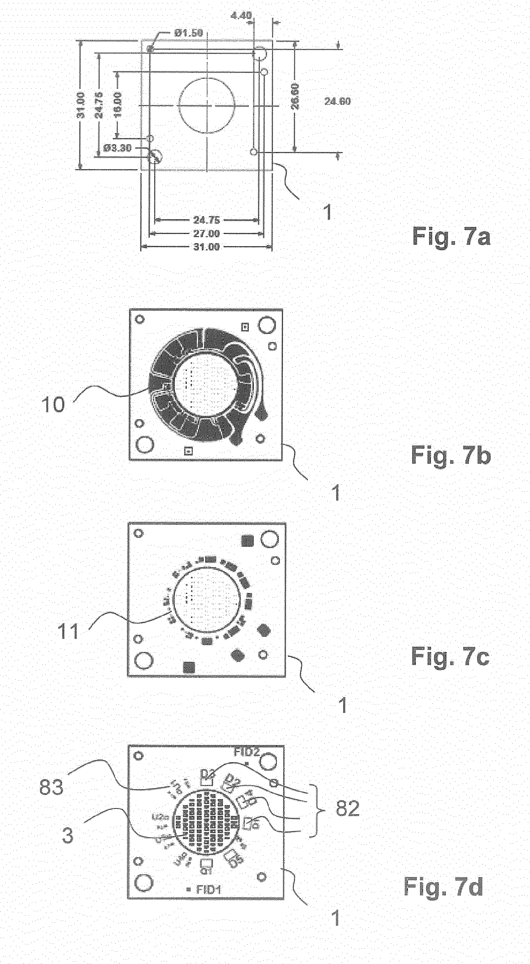

In den Fig. 7a bis 7d ist ein siebtes bevorzugtes Ausführungsbeispiel eines erfindungsgemäßen LED-Moduls, teilweise in COB-Technologie und teilweise in SMT bereitgestellt, dargestellt. Das LED-Modul gemäß Fig. 7a bis 7d umfasst die Komponenten des Ersatzschaltbilds gemäß Fig. 6.

In Fig. 7a ist das Basissubstrat 1 in Draufsicht dargestellt. Zudem sind Löcher zum Montieren des LED-Moduls dargestellt. Die Abmessungen in Fig. 7a sind als beispielhaft anzusehen.

Die Fig. 7b zeigt bereits, dass das LED-Modul sowohl in COB-Technologie als auch teilweise in SMT aufgebaut ist. Zur Verdrahtung der SMD-Bauteile ist auf der Isolationsschicht 2 eine elektrische Verdrahtungsschicht 10 ausgebildet, auch als Kupfer-Top-Schicht bezeichnet. An diese Verdrahtung wird die Wechselspannung 81 angelegt und die SMD Bauteile werden daran bestückt.

Die Fig. 7c zeigt eine Lötstopplack-Schicht 11, oberhalb der Verdrahtungsschicht 10 gemäß Fig. 7b. Dieser Lötstopplack 11, auch als Lötstoppmaske, Soldermask oder Stopplack bezeichnet, erfüllt auf dem Basissubstrat 1 unterschiedliche Funktionen. Er dient zum Schutz des Basissubstrats 1 vor Korrosion, mechanischer Beschädigung und verhindert beim Löten das Benetzen der mit ihm überzogenen Flächen auf dem Basissubstrat 1. Des Weiteren verbessert der Lötstopplack 11 die elektrischen Eigenschaften wie die Durchschlagsfestigkeit. Als Material für einen Lötstopplack 11 kommt zum Beispiel Epoxidharz zum Einsatz.

In der Fig. 7d ist nun die Bestückung mit SMD-Bauteilen auf dem Basissubstrat 1 vorgesehen. Im gewählten Beispiel sind der Brückengleichrichter 82 mit den Dioden D1 bis D4, die Mikrokontroller bzw. Konstantstromquellen 83, der Schalter Q1 und die Diode D5 gemäß dem Ersatzschaltbild aus Fig. 6 als SMD-Teile auf dem Basissubstrat 1 angebracht. Im Inneren des Basissubstrats 1 werden die 84 LED-Die 3 gemäß der oben angegebenen Art und Weise eingebracht. Dabei kann auf der Aluminiumplattform 1 eine elektrisch isolierende Schicht 2, beispielsweise eine Kunststoffschicht aufgebracht, sein, um den Isolierungsvorschriften für Direct-AC LED-Modulen zu entsprechen. Die LED-Chips 3 haben auf ihrer Unterseite eine isolierende Saphirschicht, die indessen nur eine Schichtdicke von beispielsweise 100 Mikrometern (pm) aufweisen und somit nicht den Anforderungen an vergossene Module mit einer Mindestisolationsstärke von 400 Mikrometer (pm) entsprechen.

Auf diese Weise kann die SMD-Technik mit der COB-Technologie kombiniert werden, wodurch Kosten reduziert und Herstellungsprozesse vereinfacht werden können.

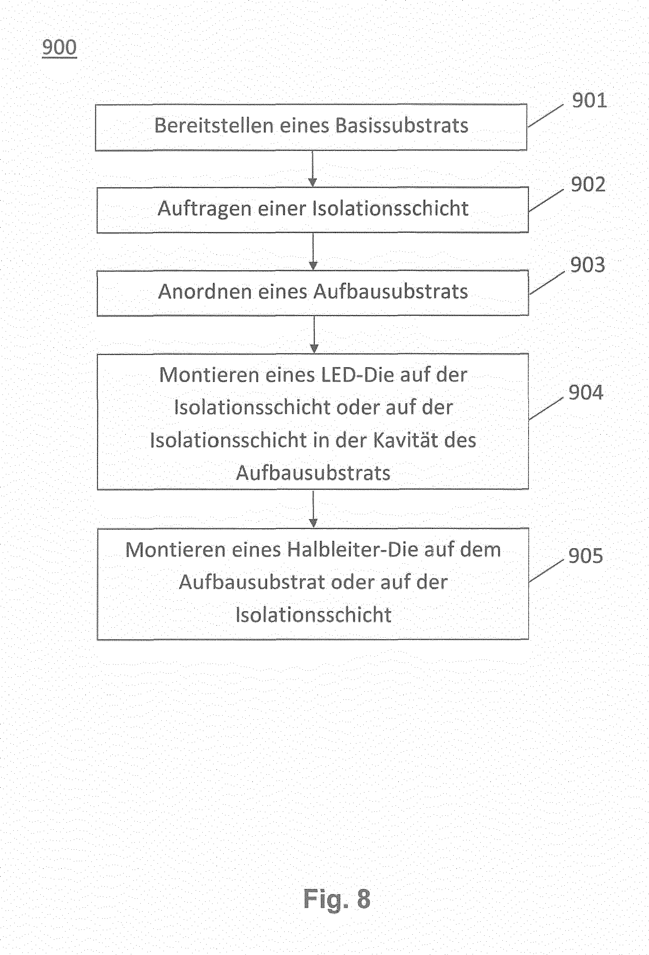

In der Fig. 8 ist ein Verfahrensablaufdiagramm für ein bevorzugtes Ausführungsbeispiel eines erfindungsgemäßen Verfahren 900 zur Herstellung eines LED-Modul in Chip-On-Board Technologie (gemäß den oben beschriebenen Alternativen 1 und 2 mit oder ohne Kavität in einem Aufbausubstrat) dargestellt. Im Schritt 901 wird dabei ein Basissubstrat 1 bereitgestellt. Im Schritt 902 wird eine Isolationsschicht 2 vollflächig auf das Basissubstrat 1 aufgetragen. Im Schritt 903 wird ein Aufbausubstrat 4 auf der Isolationsschicht 2 angeordnet. Das Aufbausubstrat weist optional eine erste Kavität K1 auf. Zusätzlich kann das Aufbausubstrat 4 optional zumindest eine zweite Kavität K2 aufweisen, welche vorzugsweise in der ersten Kavität K1 ausgebildet oder angeordnet ist. Im Schritt 904 erfolgt das Montieren zumindest eines LED-Die 3 auf der Isolationsschicht 2 (wenn das Aufbausubstrat 4 keine erste Kavität K1 aufweist) oder in der ersten Kavität K1 auf der Isolationsschicht 2 (wenn das Aufbausubstrat 4 eine erste Kavität K1 aufweist). Im Schritt 905 erfolgt die Montage zumindest eines vorzugsweise als gehäuseloser Halbleiterchip ausgebildeten weiteren Halbleiter-Die 5 auf dem Aufbausubstrat 4 (erfindungsgemäße Alternative 1) oder auf der Isolationsschicht 2 (nicht erfindungsgemäße Alternative 2), wobei der Halbleiter-Die 5 zumindest eine weitere elektronische Komponente 8 aufweist, mit der der LED-Die 3 geschaltet wird. Vorzugsweise wird der zumindest eine weitere Halbleiter-Die 5 in dem Schritt 905 in zumindest einer zweiten Kavität K2 angeordnet bzw. montiert (wenn das Aufbausubstrat 4 zumindest eine zweite Kavität K2 aufweist).

Die Erfindung ist durch die beigefügten Patentansprüche definiert.

### Bezugszeichenliste

- 1: Basissubstrat
- 2: Isolationsschicht
- 3: LED-Die, LED
- 4: Aufbausubstrat
- 5: Halbleiter-Die
- 6: Damm
- 7: Konversionsmaterial
- 8: Elektronische Komponente
- 81: AC Anschluss
- 82: Gleichrichter
- 83: Mikrokontroller
- 900: Verfahren
- 901: Bereitstellen-Schritt
- 902: Auftragen-Schritt
- 903: Anordnen-Schritt
- 904: Montieren-Schritt für LED-Die
- 905: Montieren-Schritt für Halbleiter-Die
- 10: Verdrahtungs-Schicht
- 11: Lötstopplack-Schicht
- D1, D2: Abstand
- K1: erste Kavität
- K2: zweite Kavität

## Patentansprüche

1. LED-Modul in Chip-On-Board Technologie, aufweisend:
**a)** ein Basissubstrat (1); wobei das Basissubstrat (1) vorzugsweise aus Aluminium, Silber oder Kupfer besteht
**b)** eine Isolationsschicht (2), die vollflächig auf dem Basissubstrat (1) ausgebildet ist;
**c)** zumindest einen LED-Die (3), der direkt auf der Isolationsschicht (2) montiert ist;
**d)** ein Aufbausubstrat (4), das auf der Isolationsschicht (2) in räumlichem Abstand (D1) zu dem zumindest einen LED-Die (3) ausgebildet ist; und
**e)** zumindest einen weiteren Halbleiter-Die (5), der zumindest eine weitere elektronische Komponente (8) aufweist, die dazu eingerichtet ist, den LED-Die (3) zu beschalten;
**f)** wobei der zumindest eine weitere Halbleiter-Die (5) auf dem Aufbausubstrat (4) in räumlichen Abstand (D2) zu dem zumindest einen LED-Die (3) angeordnet ist.

2. LED-Modul nach Anspruch 1,
- wobei das Aufbausubstrat (4) eine erste Kavität (K1) aufweist, in der der zumindest eine LED-Die (3) angeordnet ist; und
- wobei der zumindest eine weitere Halbleiter-Die (5) in der Peripherie des Übergangs zwischen dem Aufbausubstrat 4 und der ersten Kavität (K1) angeordnet ist.

3. LED-Modul nach Anspruch 1 oder 2,
- wobei die Oberfläche des Basissubstrats (1) optisch reflektierend ist; und
- wobei die Isolationsschicht (2) optisch transparent oder reflektierend ist.

4. LED-Modul nach einem der vorhergehenden Ansprüche, wobei der zumindest eine weitere Halbleiter-Die (5) oder zumindest ein LED-Die (3) direkt auf dem Aufbausubstrat (4), auf der Isolationsschicht (2) oder auf einem Submount als gehäuseloser Halbleiterchip montiert ist.

5. LED-Modul nach einem der vorhergehenden Ansprüche, wobei die zumindest eine weitere elektronische Komponente (8) eine Sicherung, ein Widerstand, eine Zenerdiode und/oder eine TVS-Diode ist, oder wobei die zumindest eine weitere elektronische Komponente (8) ein Feldeffekttransistor, ein Mikrocontroller (83), eine Konstantstromquelle (83) oder ein Gleichrichter (82) ist.

6. LED-Modul nach einem der vorhergehenden Ansprüche,
- wobei das LED-Modul zumindest eine zweite Kavität (K2) aufweist; und
- wobei der zumindest eine weitere Halbleiter-Die (5) in der zumindest einen zweiten Kavität (K2) angeordnet ist.

7. LED-Modul nach einem der vorhergehenden Ansprüche,
- wobei der zumindest eine LED-Die (3) mit einem Wellenlängenkonversionsmaterial (7) umhüllt ist; oder
- wobei der zumindest eine LED-Die (3) und der zumindest eine weitere Halbleiter-Die (5) mit einem Wellenlängenkonversionsmaterial (7) umhüllt ist.

8. LED-Modul nach einem der vorhergehenden Ansprüche, wobei der zumindest eine weitere Halbleiter-Die (5) mit einer reflektierenden oder transparenten Vergussmasse umhüllt und/oder abgedeckt ist.

9. LED-Modul nach einem der vorhergehenden Ansprüche, wobei das LED-Modul eine Sicherung als zumindest eine weitere elektronische Komponente (8) aufweist, wobei die Sicherung als Bonddraht in einer Kavität (K) des Aufbausubstrats (4) ausgebildet ist, oder
wobei das LED-Modul eine Sicherung als zumindest eine weitere elektronische Komponente (8) aufweist, wobei die Sicherung als Drahtschleife ausgebildet ist.

10. LED-Modul nach einem der vorhergehenden Ansprüche, wobei das Aufbausubstrat (4) eine metallische Oberfläche aufweist, auf der die zumindest eine weitere elektronische Komponente (8) angeordnet ist.

11. Verfahren (900) zur Herstellung eines LED-Modul gemäß einem der vorhergehenden Ansprüchen in Chip-On-Board Technologie mit den Verfahrensschritten:
**a)** Bereitstellen (901) eines Basissubstrat (1);
**b)** Auftragen (902) einer Isolationsschicht (2), vollflächig auf das Basissubstrat (1);
**c)** Montieren (905) zumindest eines LED-Die (3) auf der Isolationsschicht (2);
**d)** Ausbilden (903) eines Aufbausubstrats (4) auf der Isolationsschicht (2) in räumlichem Abstand (D1) zu dem zumindest einem LED-Die (3);
**e)** Montieren (906) zumindest eines weiteren Halbleiter-Die (5) in dem LED-Modul, wobei der zumindest eine weitere Halbleiter-Die (5) zumindest eine weitere elektronische Komponente (8) aufweist, die dazu eingerichtet ist, den LED-Die (3) zu beschalten; und
**f)** Montieren (906) des zumindest einen weiteren Halbleiter-Die (5) auf dem Aufbausubstrat (4) in räumlichen Abstand (D2) zu dem zumindest einen LED-Die (3).

12. Verfahren (900) nach Anspruch 11, wobei das Aufbausubstrat (4) eine erste Kavität (K1) aufweist und das Verfahren ferner folgende Verfahrensschritte aufweist:
- Montieren (905) des zumindest einen LED-Die (3) in der ersten Kavität (K1) auf der Isolationsschicht (2); und
- Anordnen des zumindest einen weiteren Halbleiter-Die (5) in der Peripherie des Übergangs zwischen dem Aufbausubstrat (4) und der ersten Kavität (K1).

13. Verfahren (900) nach Anspruch 11 oder 12, das ferner folgenden Verfahrensschritt aufweist:
- Umhüllen des zumindest einen LED-Die (3) mit einem Wellenlängenkonversionsmaterial (7); oder
- Umhüllen des zumindest einen LED-Die (3) und des zumindest einen weiteren Halbleiter-Die (5) mit einem Wellenlängenkonversionsmaterial (7).

## Claims

1. LED module in chip-on-board technology comprising:
a) a base substrate (1); wherein the base substrate (1) preferably consists of aluminum, silver or copper
b) an insulation layer (2), which is formed over the entire surface of the base substrate (1);
c) at least one LED die (3), which is mounted directly on the insulation layer (2);
d) a mounting substrate (4), which is formed on the insulation layer (2) at a spatial distance (D1) from the at least one LED die (3); and
e) at least one further semiconductor die (5) comprising at least one further electronic component (8) which is configured to connect the LED die (3);
f) wherein the at least one further semiconductor die (5) is disposed on the mounting substrate (4) at a spatial distance (D2) from the at least one LED die (3).

2. LED module according to Claim 1,
- wherein the mounting substrate (4) comprises a first cavity (K1) in which the at least one LED die (3) is disposed; and
- wherein the at least one further semiconductor die (5) is disposed in the periphery of the transition between the mounting substrate (4) and the first cavity (K1).

3. LED module according to Claim 1 or 2,
- wherein the surface of the base substrate (1) is optically reflective; and
- wherein the insulation layer (2) is optically transparent or reflective.

4. LED module according to any one of the preceding claims, wherein the at least one further semiconductor die (5) or at least one LED die (3) is mounted directly on the mounting substrate (4), on the insulation layer (2) or on a submount as an unpackaged semiconductor chip.

5. The LED module according to any one of the preceding claims, wherein the at least one further electronic component (8) is a fuse, a resistor, a Zener diode, and/or a TVS diode, or wherein the at least one further electronic component (8) is a field-effect transistor, a microcontroller (83), a constant current source (83), or a rectifier (82).

6. LED module according to any one of the preceding claims,
- wherein the LED module comprises at least one second cavity (K2); and
- wherein the at least one further semiconductor die (5) is disposed in the at least one second cavity (K2).

7. LED module according to any one of the preceding claims,
- wherein the at least one LED die (3) is encased with a wavelength conversion material (7); or
- wherein the at least one LED die (3) and the at least one further semiconductor die (5) are encased with a wavelength conversion material (7).

8. LED module according to any one of the preceding claims, wherein the at least one further semiconductor die (5) is encased and/or covered with a reflective or transparent casting compound.

9. LED module according to any one of the preceding claims, wherein the LED module comprises a fuse as at least one further electronic component (8), wherein the fuse is configured as a bonding wire in a cavity (K) of the mounting substrate (4), or
wherein the LED module comprises a fuse as at least one further electronic component (8), wherein the fuse is configured as a wire loop.

10. LED module according to any one of the preceding claims, wherein the mounting substrate (4) has a metallic surface on which the at least one further electronic component (8) is disposed.

11. Method (900) for producing an LED module according to any one of the preceding Claims in chip-on-board technology comprising the method steps:
a) providing (901) a base substrate (1);
b) applying (902) an insulation layer (2) over the entire surface of the base substrate (1);
c) mounting (905) at least one LED die (3) on the insulation layer (2);
d) forming (903) a mounting substrate (4) on the insulation layer (2) at a spatial distance (D1) from the at least one LED die (3) ;
e) mounting (906) at least one further semiconductor die (5) in the LED module, wherein said at least one further semiconductor die (5) comprises at least one further electronic component (8) which is configured to connect the LED die (3); and
f) mounting (906) the at least one further semiconductor die (5) on the mounting substrate (4) at a spatial distance (D2) to the at least one LED die (3).

12. Method (900) according to Claim 11, wherein the mounting substrate (4) comprises a first cavity (K1) and the method further comprises the following method steps:
- mounting (905) the at least one LED die (3) in the first cavity (K1) on the insulation layer (2); and
- disposing the at least one further semiconductor die (5) in the periphery of the transition between the mounting substrate (4) and the first cavity (K1).

13. Method (900) according to Claim 11 or 12 further comprising the following method step:
- encasing the at least one LED die (3) with a wavelength conversion material (7); or
- encasing the at least one LED die (3) and the at least one further semiconductor die (5) with a wavelength conversion material (7).

## Revendications

1. Module LED équipé de la technologie chip on board, présentant :
a) un substrat de base (1) ; le substrat de base (1) se composant de préférence d'aluminium, d'argent ou de cuivre
b) une couche isolante (2) formée sur toute la surface du substrat de base (1) ;
c) au moins une puce LED (3) montée directement sur la couche isolante (2) ;
d) un substrat de montage (4) formé sur la couche isolante (2) à distance spatiale (D1) de l'au moins une puce LED (3) ; et
e) au moins une autre puce à semi-conducteur (5) comportant au moins un autre composant électronique (8) conçu pour le câblage de la puce LED (3) ;
f) l'au moins une autre puce à semi-conducteur (5) étant agencée sur le substrat de montage (4) à distance spatiale (D2) de l'au moins une puce LED (3).

2. Module LED selon la revendication 1,
- le substrat de montage (4) présentant une première cavité (K1) dans laquelle l'au moins une puce LED (3) est agencée, et
- l'au moins une autre puce à semi-conducteur (5) étant agencée à la périphérie de la transition entre le substrat de montage (4) et la première cavité (K1).

3. Module LED selon la revendication 1 ou 2,
- la surface du substrat de base (1) étant optiquement réfléchissante, et
- la couche d'isolation (2) étant optiquement transparente ou réfléchissante.

4. Module LED selon l'une quelconque des revendications précédentes, dans lequel l'au moins une autre puce à semi-conducteur (5) ou l'au moins une puce LED (3) est montée directement sur le substrat de montage (4), sur la couche isolante (2) ou sur un support sous-jacent, sous la forme d'une puce nue sans boîtier.

5. Module LED selon l'une quelconque des revendications précédentes, dans lequel l'au moins un autre composant électronique (8) est un fusible, une résistance, une diode Zener et/ou une diode d'écrêtage, ou dans lequel l'au moins un autre composant électronique (8) est un transistor à effet de champ, un microcontrôleur (83), une source de courant constant (83) ou un redresseur (82).

6. Module LED selon l'une quelconque des revendications précédentes,
- le module LED présentant au moins une deuxième cavité (K2), et
- l'au moins une autre puce à semi-conducteur (5) étant agencée dans l'au moins une deuxième cavité (K2).

7. Module LED selon l'une quelconque des revendications précédentes,
- l'au moins une puce LED (3) étant enveloppée d'un matériau de conversion de longueur d'onde (7), ou
- l'au moins une puce LED (3) et l'au moins une autre puce à semi-conducteur (5) étant enveloppées d'un matériau de conversion de longueur d'onde (7).

8. Module LED selon l'une quelconque des revendications précédentes, dans lequel l'au moins une autre puce à semi-conducteur (5) est enveloppée et/ou recouverte d'un composé d'enrobage réfléchissant ou transparent.

9. Module LED selon l'une quelconque des revendications précédentes, ledit module LED présentant un fusible en guise d'au moins un autre composant électronique (8), le fusible étant conçu sous la forme d'un fil de connexion dans une cavité (K) du substrat de montage (4), ou
le module à LED comportant un fusible en guise d'au moins un autre composant électronique (8), le fusible étant conçu sous la forme d'une boucle de fil.

10. Module LED selon l'une quelconque des revendications précédentes, dans lequel le substrat de montage (4) présente une surface métallique sur laquelle est agencé l'au moins un autre composant électronique (8).

11. Procédé (900) pour la fabrication d'un module LED équipé de la technologie chip on board selon l'une des revendications précédentes, le procédé comprenant les étapes suivantes :
a) mise à disposition (901) d'un substrat de base (1) ;
b) application (902) d'une couche isolante (2) sur toute la surface du substrat de base (1) ;
c) montage (905) d'au moins une puce LED (3) sur la couche isolante (2) ;
d) formation (903) d'un substrat de montage (4) sur la couche isolante (2) à distance spatiale (D1) de l'au moins une puce LED (3) ;
e) montage (906) d'au moins une autre puce à semi-conducteur (5) dans le module LED, l'au moins une autre puce à semi-conducteur (5) présentant au moins un autre composant électronique (8) conçu pour le câblage de la puce LED (3) ; et
f) montage (906) de l'au moins une autre puce à semi-conducteur (5) sur le substrat de montage (4) à distance spatiale (D2) de l'au moins une puce LED (3).

12. Procédé (900) selon la revendication 11, dans lequel le substrat de montage (4) présente une première cavité (K1), le procédé comprenant en outre les étapes suivantes :
- montage (905) de l'au moins une puce LED (3) dans la première cavité (K1) sur la couche isolante (2), et
- agencement de l'au moins une autre puce à semi-conducteur (5) à la périphérie de la transition entre le substrat de montage (4) et la première cavité (K1).

13. Procédé (900) selon la revendication 11 ou 12, présentant en outre l'étape suivante :
- enveloppement de l'au moins une puce LED (3) avec un matériau de conversion de longueur d'onde (7), ou
- enveloppement de l'au moins une puce LED (3) et de l'au moins une autre puce à semi-conducteur (5) avec un matériau de conversion de longueur d'onde (7).
